Europäisches Patentamt

European Patent Office

Office européen des brevets

(11) Publication number: **0 214 705 B1**

(12) **EUROPEAN PATENT SPECIFICATION**

(45) Date of publication of patent specification: **15.01.92**

(21) Application number: **86201618.5**

(22) Date of filing: **07.10.81**

(51) Int. Cl.5: **G11C 17/00, G11C 11/34**

(60) Publication number of the earlier application in accordance with Art.76 EPC: **0 050 005**

(54) Semiconductor memory with improvend data programming time.

(30) Priority: **15.10.80 JP 143947/80**
**15.10.80 JP 143948/80**
**15.10.80 JP 143949/80**

(43) Date of publication of application:
**18.03.87 Bulletin 87/12**

(45) Publication of the grant of the patent:
**15.01.92 Bulletin 92/03**

(84) Designated Contracting States:
**DE FR GB**

(56) References cited:
**GB-A- 2 053 611**
**US-A- 3 686 640**

**PATENT ABSTRACTS OF JAPAN, vol. 1, no. 146, 26th November 1977, page 7445 E 77; & JP-A-52 85 429 (HITACHI SEISAKUSHO K.K.) 15-07-1977**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Iwahashi, Hiroshi**
**63-10 Shikimidai**
**Asahi-ku,Yokohama-shi(JP)**
Inventor: **Asano, Masamichi**
**2-24-12, Naka-cho**
**Musashino-shi Tokyo(JP)**

(74) Representative: **Freed, Arthur Woolf et al**
**MARKS & CLERK 57-60 Lincoln's Inn Fields**
**London WC2A 3LS(GB)**

Rank Xerox (UK) Business Services

**Description**

The present invention relates to a semiconductor memory and, more particularly, a nonvolatile semiconductor memory using, as memory cells, field effect transistors each including a floating gate within a gate insulating film.

In a nonvolatile semiconductor memory such as an erasable and electrically programmable read only memory (EPROM) using field effect transistors each having a floating gate within an insulating film, to program a memory cell, that is, to inject electrons into the floating gate, a program voltage (e.g. 25 V) is simultaneously applied to the gate and drain of a memory insulating gate field effect transistor. Usually, about 50 milliseconds are taken to program a single memory cell. In this case, the programming is performed every word. Accordingly, about 1.7 minutes are taken to program all the memory cells of a memory of 2048 words × 8 bits, and about 3.4 minutes for a memory of 4096 words × 8 bits.

In the die sort process of semiconductor memories, all the dies on a single wafer are tested as to whether all the memory cells can be programmed or not. In the case of the memory of 4096 words × 8 bits, if 150 dies, for example, fabricated on a single wafer, time taken for the programming test of all of the dies is 3.4 minutes x 150 = 510 minutes, or 8.5 hours.

The same thing can be said for actual data programming of semiconductor memories. A long programming time is taken for programming memories word by word.

It is known from Us Patent No. 3686640 to provide a semiconductor memory having a plurality of memory arrays each having a plurality of memory cells arranged in a matrix form with column lines and row lines and a plurality of bit outputs; decoder means responsive to first address signals to select corresponding memory cells in said memory arrays; a plurality of data write circuits coupled to said memory arrays for writing data into corresponding memory arrays; and a write circuit selecting circuit responsive to second address signals to select one of said write circuits to write data into a corresponding memory array.

In order to reduce the duration of a memory ability test, the present invention provides a memory of the above type, characterised in that it further comprises multiple-write means responsive to a control signal to modify said second address signals, in a program test mode for testing the ability of the memory, so as to cause said write circuit selecting circuit to select simultaneously more than one of said memory arrays whereby the same test data to be programmed which is applied to the memory cell is written immediately into the selected arrays.

According to an embodiment of the present invention, the memory array is divided into a plurality of memory array blocks. One of the memory array blocks is selected by address signals. In a simultaneous data write mode, a pair of address signals is made in-phase by a control signal, so that a plurality of memory array blocks are selected and memory cells addressed by decoders, in each of the selected memory blocks, are simultaneously programmed.

Embodiments of the invention will now be described by way of example, with reference to the accompanying drawings, in which:

Fig. 1 schematically shows a non volatile memory;

Fig. 2 schematically shows another nonvolatile memory;

Fig. 3 illustrates a nonvolatile memory according to a further embodiment of the present invention;

Fig. 4 shows a practical arrangement of an address buffer circuit controlled by the multiple-write switching circuit in Fig. 3;

Fig. 6 shows a practical arrangement of a memory block selecting circuit in Fig. 3;

Fig. 7 illustrates a practical arrangement of row and column decoders in Fig. 3;

Fig. 8 shows a practical arrangement of a selecting circuit for write-load circuits in Fig. 3;

Fig. 9 shows a practical arrangement of the write-load circuits in Fig. 3;

Fig. 10 shows a practical arrangement of a data-write circuit in Fig. 3;

Fig. 11 shows a modification of the memory in Fig. 3;

Fig. 12 schematically shows another memory, and

Figs. 13 and 14 show practical arrangements of a data input circuit in Fig. 12.

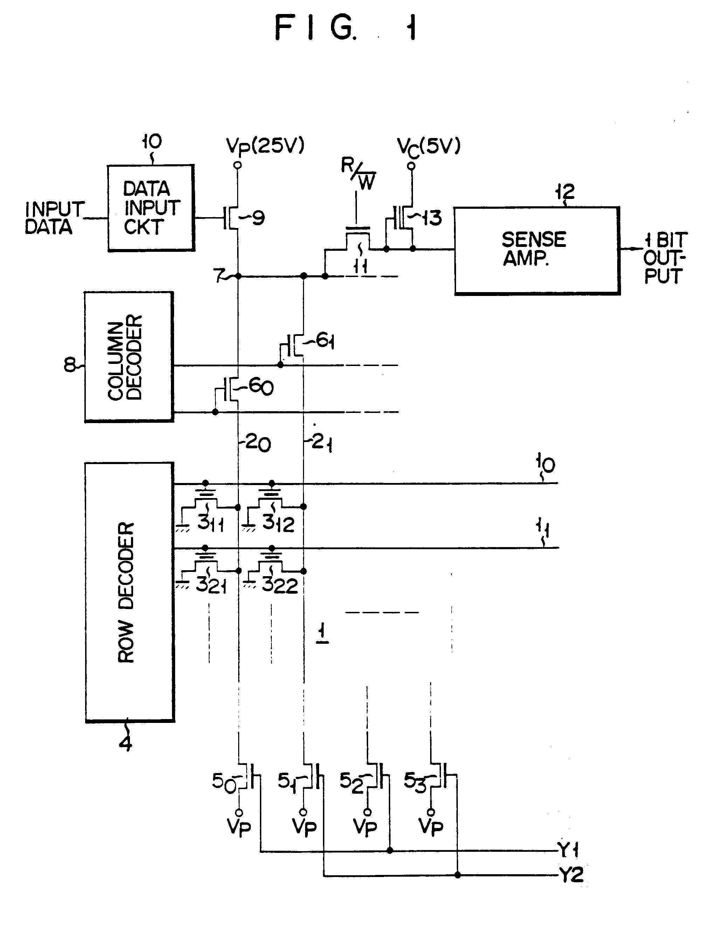

Referring to Fig. 1, there is shown a nonvolatile semiconductor memory which comprises a memory array 1 having row lines $1_0$, $1_1$, ..., column lines $2_0$, $2_1$, ..., and floating gate type MOS transistors $3_{11}$, $3_{12}$, ..., $3_{21}$, $3_{22}$, ... acting as memory cells. The MOS transistors have their sources grounded, their drains connected to corresponding column lines, and their gates connected with corresponding row lines.

The row lines $1_0$, $1_1$, ... are connected to a row (x) decoder 4. Ends of the column lines $2_0$, $2_1$, ... are connected with a power source of program voltage Vp via insulating-gate field effect transistors (IGFET) $5_0$, $5_1$, $5_2$, $5_3$, .... The other ends of the column lines are coupled with a common terminal 7 by way of column

selecting IGFET's $6_0$, $6_1$, .... Gates of the IGFET's $5_0$, $5_2$, ..., are supplied with a gate signal Y1, while gates of the IGFET's $5_1$, $5_3$, ..., are supplied with a gate signal Y2. Gates of the IGFET's $6_0$, $6_1$, ... are connected with the corresponding outputs (column selecting lines) of a column decoder 8. The common terminal 7 is coupled with the source of program voltage Vp through an IGFET 9 having its gate coupled with the output of a data input circuit 10 supplied with input data. The common terminal 7 is connected to a sense amplifier/output buffer circuit 12 through an IGFET 11 supplied with a data readout instruction signal R/$\overline{W}$ at its gate. The input terminal of sense amplifier 12 is connected with a power source Vc (5 V, for example) via a depletion mode IGFET 13 having its gate connected with the input of sense amplifier 12.

The sense amplifier 12 provides a 1 output bit. When one word stored in the memory consists of 4 bits, or the memory has 4 bit outputs, four sense amplifiers are provided. The same thing is true for the data input circuit 10.

In order to examine whether all of the memory cells of the nonvolatile memory can be written or not, the IGFET's $5_0$, $5_1$, $5_2$, $5_3$, ..., are turned on by raising the levels of gate signals Y1 and Y2 up to the program voltage Vp. As a result, the program voltage Vp is applied to all the column lines. Under this condition, when the levels of row lines $1_0$, $1_1$,... are successively raised to the level of the program voltage Vp by row decoder 4, the gates and drains of the floating-gate IGFET's connected with each row line are supplied with voltages Vp and (Vp - Vth), respectively, so that memory transistors are programmed. Vth represents a threshold voltage of each of IGFET's $5_0$, $5_1$, $5_2$, $5_3$, ....

As described above, with this memory, since all of the memory cells connected to the respective row lines are programmed simultaneously, a program test time is remarkably reduced compared with a conventional memory. The memory cells are not only simultaneously programmed but also supplied with program data at the same time. Namely, this obviates the necessity of a special circuit for simultaneous data programming such as a latch circuit.

Alternatively, the gate signals Y1 and Y2 may be alternately raised to the program voltage Vp such that the gate signal Y1 is raised when row line $1_0$ is selected and the gate signal Y2 is raised when the row line $1_1$ is selected. In this case, data 1 is written into alternate memory cells connected to each row line, and data 0 is written into the remaining memory cells. In this case, data 1 represents a state that electrons are not injected into the floating gate of memory cell, while data 0 represents a state that electrons have been injected into the floating gate. It is to be understood that the gate signals Y1 and Y2 are raised up to the program voltage Vp only during the test process of memory devices, and therefore the gate signals are zero volt during a formal data programming time.

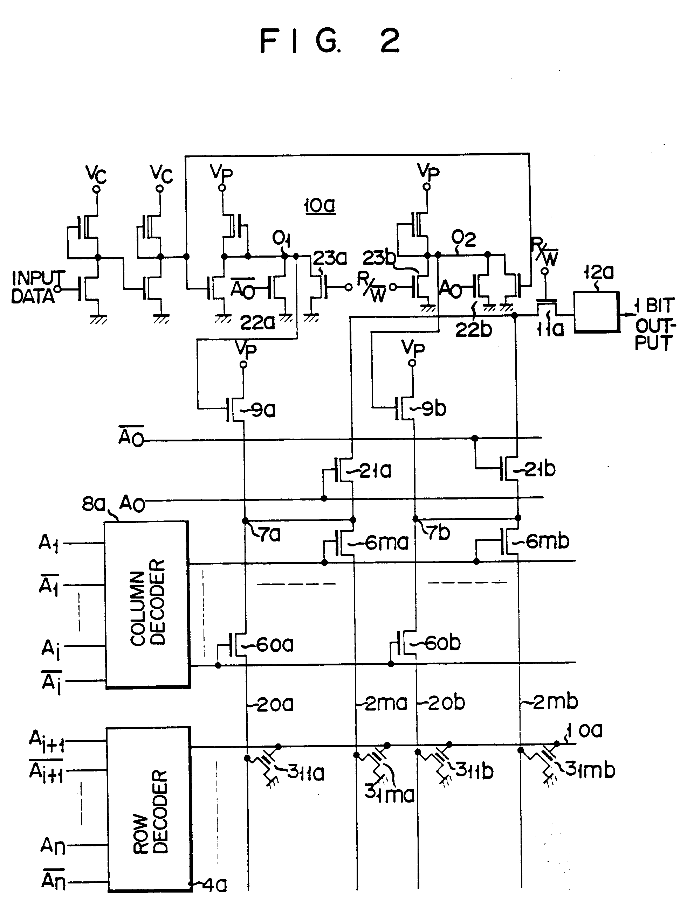

Fig. 2 shows another embodiment of a nonvolatile semiconductor memory With this embodiment, by making a pair of column selecting address signals in-phase, the program voltage Vp is simultaneously applied to two of the column lines for one output bit which are selected by the column decoder so that a couple of memory cells connected to a row line selected by the row decoder are simultaneously programmed.

As shown in Fig. 2, in this embodiment, a pair of common terminals 7a and 7b are provided which are coupled to the program voltage Vp through IGFET's 9a and 9b. The common terminals 7a and 7b are connected to a data readout FET 11a followed by sense amplifier 12a, by way of IGFET's 21a and 21b supplied with address signals A0 and $\overline{A}$0, respectively. Further, common terminal 7a is coupled with column lines 2oa to 2ma via column selecting FET's 6oa to 6ma, gates of which are connected to the outputs of column decoder 8a, respectively. The common terminal 7b is connected with column lines 2ob to 2mb by way of column selecting FET's 6ob to 6mb, having gates connected with the outputs of column decoder 8a, respectively. Column lines 2oa to 2ma and 2ob to 2mb are connected to drains of floating-gate FET's $3_{11a}$ to $3_{1ma}$ and $3_{11b}$ to $3_{1mb}$. Gates of IGFET's 9a and 9b are respectively connected to output terminals $0_1$ and $0_2$, of data input circuit 10a. Output terminal $0_1$ is grounded through an IGFET 22a and an IGFET 23a. The gate of IGFET 22a is supplied with address signal $\overline{A}$0, and the gate of IGFET 23a is supplied with an R/$\overline{W}$ signal. On the other hand, output terminal $0_2$ is grounded through an IGFET 22b and an IGFET 23b. The gate of IGFET 22b is supplied with address signal A0 and the gate of IGFET 23b is supplied with R/$\overline{W}$ signal.

In the memory arranged as above, in order to write data into memory cells for a program test, the address input signals A0 and $\overline{A}$0 and the R/$\overline{W}$ signal are set at logic 0 level. As a result, IGFET's 11a, 21a, 21b, 22a, 22b, 23a and 23b are turned off. Under this condition, when logic 0 data is applied to data input circuit 10a, output terminals $0_1$ and $0_2$ go to the logic 1 level (in this case, Vp level), to turn ON IGFET's 9a and 9b. This means that program data is simultaneously applied to two memory cells. As a result, common terminals 7a and 7b are connected with the program voltage Vp, so that the program voltage Vp is applied to a pair of the column lines selected by column decoder 8a. This implies that a couple of memory cells connected to the selected column lines and the row line selected by row decoder 4a are programmed

EP 0 214 705 B1

simultaneously. For example, in Fig. 2, either a pair of memory cells $3_{11a}$ and $3_{11b}$ or $3_{1ma}$ and $3_{1mb}$ is simultaneously programmed. Thus, in the memory shown in Fig. 2, the program test time is halved compared with the prior art memory. As stated above, the requirement of a data latch circuit for data programming is obviated.

In Fig. 2, in order to write memory cells formally, address signals A0 and $\overline{A0}$ are set in a complementary relation. For example, when A0 = 1 and $\overline{A0}$ = 0, IGFET 22b is ON. Therefore, output terminal $0_2$ is at substantially ground level, and the IGFET 9b is OFF. Meanwhile, depending on input data, output terminal $0_1$ goes to logic 1 level or logic 0 level. Consequently, one memory cell selected by row decoder 4a and column decoder 8a is written with data of 0 or 1. In this case, data 1 corresponds to logic 1 of input data. At this time, the terminal $0_1$ is at logic 0 level and transistor 9a remains off. Namely, writing data 1 into a memory cell means that the floating-gate of memory cell is neutral.

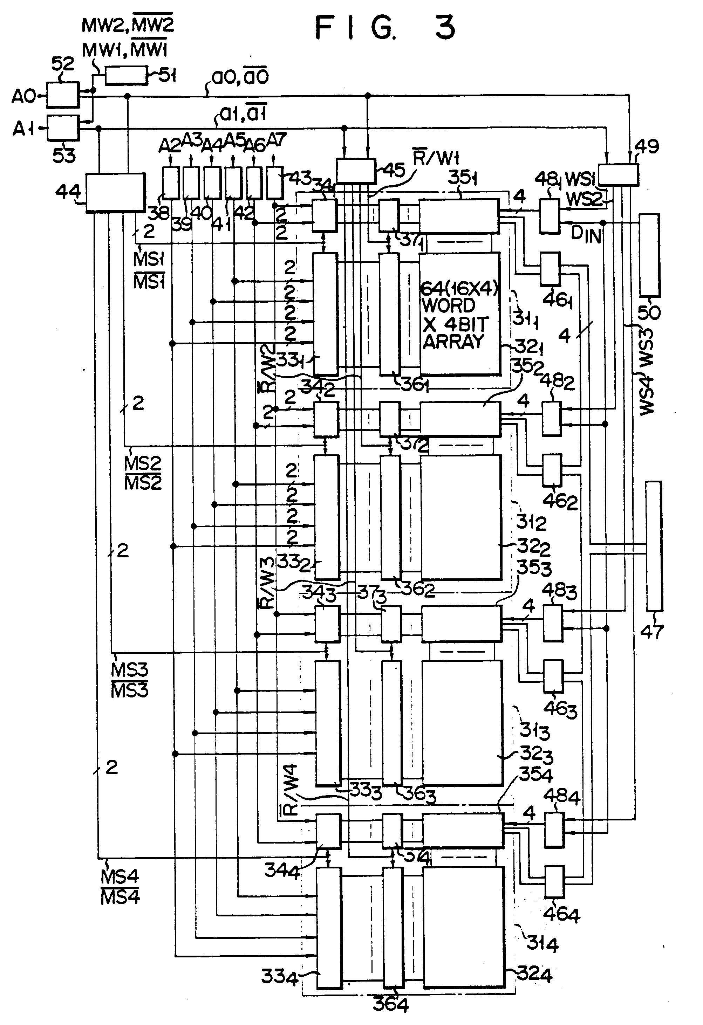

Fig. 3 shows an embodiment of a nonvolatile semiconductor memory of the present invention. In this embodiment, the memory array is divided into four blocks. And the corresponding memory cells in four or two memory blocks (16 or 8 cells when a word consists of 4 bits) are simultaneously programmed.

In Fig. 3, reference numerals $31_1$ to $31_4$ designate the memory blocks. These memory blocks include respectively memory arrays $32_1$ to $32_4$, row decoders $33_1$ to $33_4$, column decoder $34_1$ to $34_4$ column selecting gate circuits $35_1$ to $35_4$, write load circuits $36_1$ to $36_4$ and write load circuit $37_1$ to $37_4$. In this embodiment, memory arrays $32_1$ to $32_4$ are each a 64 (16 x 40) words by 4 bits array.

Address signals A2 to A5 are applied to each of row decoders $33_1$ to $33_4$ via address buffers 38 to 41, respectively, while address signals A6 and A7 are applied to each of column decoders $34_1$ to $34_4$ by way of address buffers 42 and 43.

Selection of the memory blocks $31_1$ to $31_4$ is performed by output signals MS1, $\overline{MS1}$ to MS4 and $\overline{MS4}$ of a memory block selecting circuit 44 fed with address signals A0 and A1. Write load circuits $36_1$ to $36_4$ and $37_1$ to $37_4$ are selectively enabled by output signals $\overline{R/W1}$, $\overline{R/W2}$, $\overline{R/W3}$ and $\overline{R/W4}$ of a load-circuit selecting circuit 45 supplied with address signals A0 and A1.

The 4-bit outputs of each of memory blocks $31_1$ to $31_4$ are coupled together with an output circuit 47 via transmission gate circuits $46_1$ to $46_4$. To memory blocks $31_1$ to $31_4$ are connected write circuits $48_1$ to $48_4$ which are selectively enabled by output signals WS1 to WS4 of write-circuit selecting circuit 49.

Circuits $48_1$ to $48_4$ each supply input data Din from an input circuit 50 to the corresponding memory block when enabled. A multiple-write circuit designated by reference numeral 51 is arranged to supply signals MW1 (MW2) and $\overline{MW1}$ ($\overline{MW2}$) to address buffers 52 and 53 to which the address signals A0 and A1 are supplied in order to set the address signals to the multiple write mode in which a plurality of memory blocks are selected and a plurality of memory cells in the selected memory blocks are concurrently programmed.

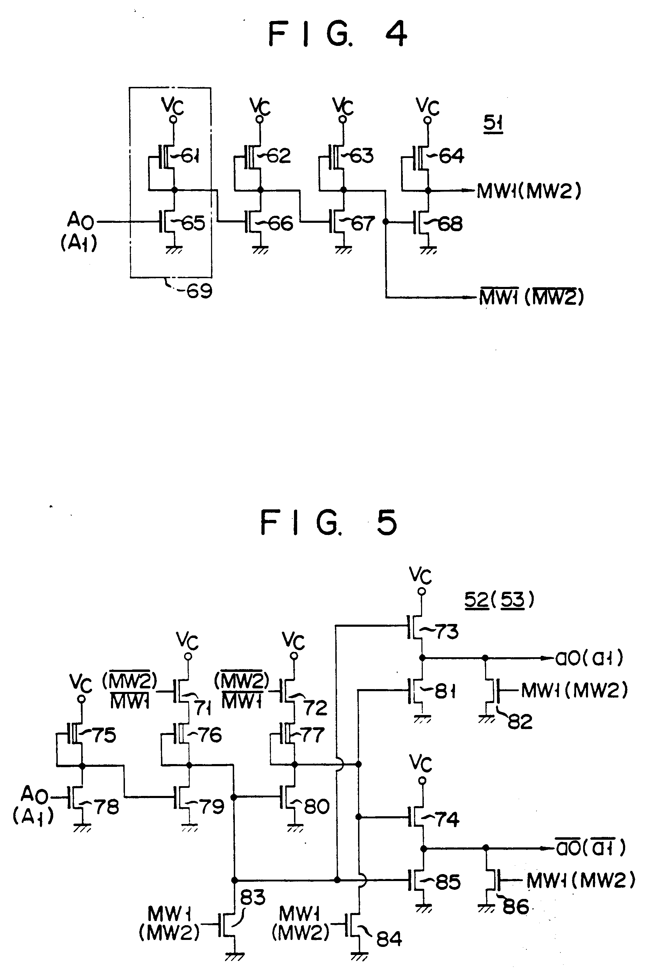

Fig. 4 shows a practical arrangement of multiple-write circuit 51. Reference numerals 61 to 64 designate depletion mode IGFET's and reference numerals 65 to 68 enhancement mode IGFET's. Address signal A0 (or A1) is applied to an inverter 69 for detecting an input voltage of 10 V or more as a logic 1. When the address signal A0 is raised to 10 V or more for multiple writing, the output signal MW1 (MW2) goes to logic 1 level, while the output signal $\overline{MW1}$ ($\overline{MW2}$) goes to logic 0 level, thus instructing address buffers 52 and 53 to execute the multiple-write. In the normal write mode, the address signal A0 (A1) is below 10 V. Under this condition, the output signal MW1 (MW2) is at logic 0 level, while the output signal ($\overline{MW1}$) ($\overline{MW2}$) is at logic 1 level.

Fig. 5 shows a practical arrangement of the address buffer 52 (or 53). Reference numerals 71 to 74 designate IGFET's the threshold voltage of which is 0 V; reference numerals 75 to 77 depletion mode IGFET's; 78 to 86 enhancement mode IGFET's. In the normal data write mode, the output signals MW1 (MW2) and $\overline{MW1}$ ($\overline{MW2}$) of multiple-write circuit 51 are respectively at logic 0 and logic 1 level. Therefore, output signals a0 (a1) and $\overline{a0}$ ($\overline{a1}$) of address buffer 52 (53) are at complementary logic levels according to the logic level of the address signal A0 (A1). However, when MW1 (MW2) = 1 and $\overline{MW1}$ ($\overline{MW2}$) = 0, that is, in the multiple-write mode, the output signals a0 (a1) and $\overline{a0}$ ($\overline{a1}$) of address buffer circuit 52 (53) both go to logic 0.

The address buffer circuits shown in Figs. 4 and 5 can be used in the memories shown in Figs. 1 and 2. If the address buffer circuit is used for address input signals to the row decoder, then a plurality of row lines can be selected concurrently so that memory cells connected to the plurality of row lines are programmed at the same time. This means, as stated above, that program data are simultaneously applied to the memory cells. For programming test, data applied to the memory cells may be identical to each other.

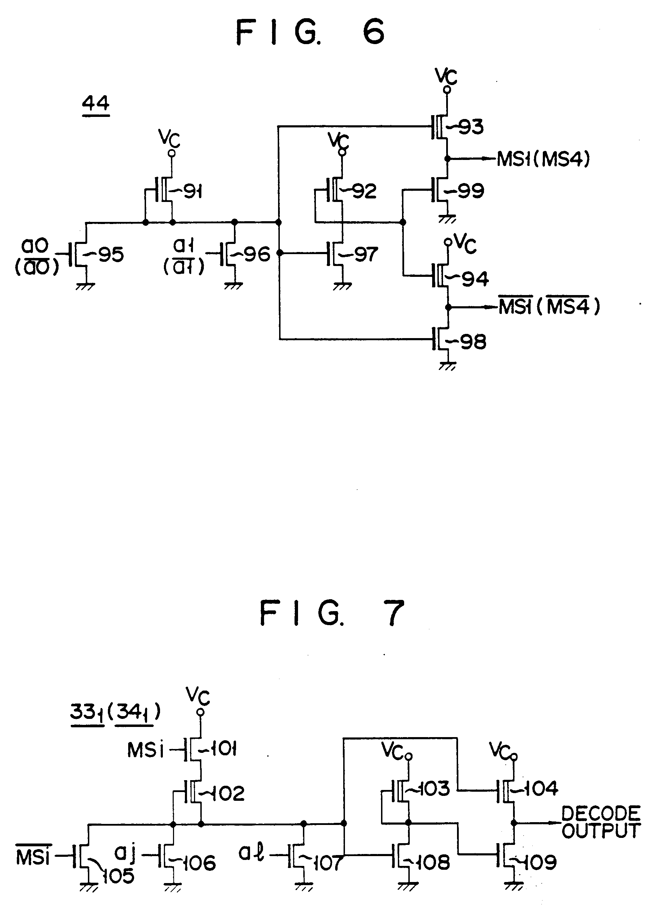

Fig. 6 shows a practical arrangement of memory block selecting circuit 44. Reference numerals 91 to 94 designate depletion mode IGFET's and numerals 95 to 99 enhancement mode IGFET's. This circuit is

4

provided for each of combinations of the output signals from address buffers 52 and 53; a0 and a1, a0 and $\overline{a}1$; a0 and a1, and $\overline{a}0$ and $\overline{a}1$.

The circuit shown in Fig. 6, for example, receives the output signals a0 ($\overline{a}0$) and a1 ($\overline{a}1$) from address buffers 52 and 53 to form output signals MS1 (MS4) and $\overline{MS1}$ ($\overline{MS4}$). In the normal data write or read mode, one of the output signals MS1 to MS4 for selecting a memory block designated is at logic 1 level and corresponding one of the signals $\overline{MS1}$ to $\overline{MS4}$ is at logic 0 level. In the multiple-write mode, the signals a0, $\overline{a}0$, a1 and $\overline{a}1$ are at logic 0, and hence the signals MS1 and MS4 are all at logic 1, while signals $\overline{MS1}$ to $\overline{MS4}$ are all at logic 0. As a result, memory blocks $32_1$ to $32_4$ are all selected.

Fig. 7 shows a practical arrangement of the row (column) decoder. Reference numeral 101 designates an IGFET the threshold voltage of which is approximately 0 V; numerals 102 to 104 depletion mode IGFET's; and numerals 105 to 109 enhancement mode IGFET's. In the case of the row decoder, for example, this circuit is provided for each of 16 combinations of the address input signals. On the other hand, in the case of the column decoder, this circuit is provided for each of four combinations of the address input signals.

In the normal operation, since MSi = 1 and $\overline{MSi}$ = 0 ($1 \leq i \leq 4$) in the selected memory block, the decode outputs, or the row or column selecting lines, take a logical state according to address signals. In the non-selected memory block, MSi = 0 and $\overline{MSi}$ = 1. Accordingly, the decode output goes to logic 0 regardless of a state of the address signals. In the multiple-write mode, as stated above, the signals MS1 to MS4 are all at logic 1 and the signals $\overline{MS1}$ to $\overline{MS4}$ are all at logic 0, so that all of the memory blocks $32_1$ to $32_4$ are selected.

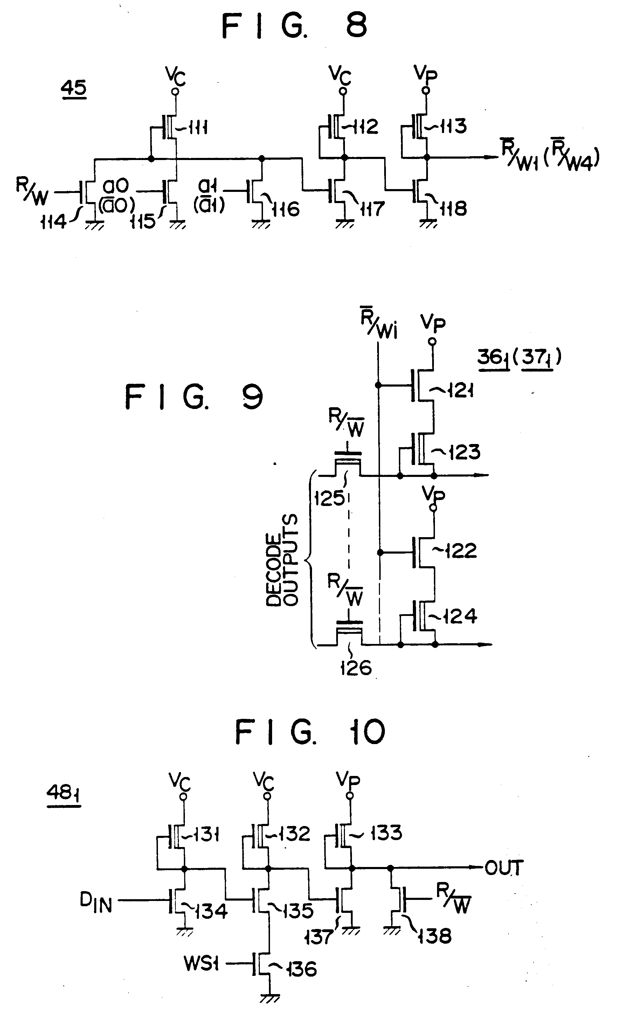

Fig. 8 shows a practical arrangement of the selecting circuit 45 for the write load circuits. Reference numerals 111 to 113 designate depletion mode IGFET's and numerals 115 to 118 enhancement mode IGFET's. This circuit is provided for each memory block. When R/W = 0, that is, in the data write mode, it supplies a signal $\overline{R}/Wi$ of logic 1 to the write load circuit of a selected memory block.

Fig. 9 shows a practical arrangement of the write load circuit. Reference numerals 121 and 122 designate enhancement mode IGFET's and numerals 123 to 126 depletion mode IGFET's. With such a circuit arrangement, when $\overline{R}/Wi$ = 1, a selected decode output is raised to Vp level and the non-selected decode outputs go to logic 0 level.

Write-circuit selecting circuit 49 is constructed substantially similar to memory block selecting circuit 44. Accordingly, it may be considered that WS1 = MS1, WS2 = MS2, WS3 = MS3 and WS4 = MS4.

Fig. 10 shows a practical arrangement of the write circuit $48_1$. In the circuit, reference numerals 123 to 133 designate depletion mode IGFET's and numerals 134 to 138 enhancement mode IGFET's. When Din = 1, WS1 = 1, and R/$\overline{W}$ = 0, the output of this circuit goes to Vp to turn on an IGFET (corresponding to IGFET 9 in Fig. 1) which supplies a program voltage to the column lines. The remaining write circuits $48_2$ to $48_4$ are also constructed similarly. In these circuits, the signals WS2, WS3 and SW4 are supplied to the FET's corresponding to FET 136.

The memory thus constructed can simultaneously program a memory array of four memory blocks, so that a program test time is reduced to 1/4 that of the prior art memory.

With this embodiment, if the address signals A0 and A1 are simultaneously set in the multiple-write mode, four memory blocks are simultaneously selected. Alternatively, one of the address signals A0 and A1 may be set in the multiple-write mode. In this case, two memory blocks are simultaneously selected. A common multiple-write switching circuit may be provided for address buffers 52 and 53. In this case, four memory blocks are simultaneously selected. For the purpose of program testing, the same data may be written into memory cells so that they are simultaneously programmed. In the above-mentioned embodiment, the address signal is used for the multiple-write switching signal, but other signals may be used instead. A terminal (pad) exclusively used for the program test may be provided to which a multiple-write switching signal is supplied.

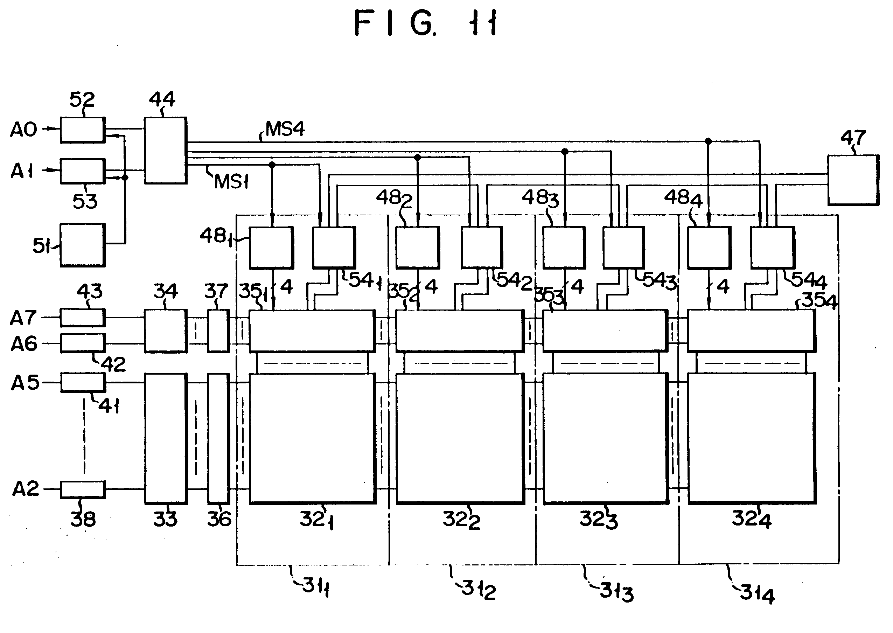

Fig. 11 shows a modification of the memory of Fig. 3 in which row and column decoders are used commonly for the memory blocks. Outputs of row selecting gate circuits $35_1$ to $35_4$ are coupled to an output circuit 47 through sense amplifiers $54_1$ to $54_4$. In the normal operation mode, the memory block selecting circuit 44 selects one of the memory blocks so that the write circuit and the sense amplifier in the memory block are enabled. In the multiple-write mode, the write circuits are all enabled to write data into memory cells, selected by row and column decoders 33 and 34, in the memory arrays $32_1$ to $32_4$. In the memory shown in Fig. 11, memory blocks $31_1$ to $31_4$ and output circuit 47 each are arranged to have 4 bit outputs. However, they may have 1 bit output. With a 4-bit output memory device, if memory blocks $31_1$ to $31_4$ and output circuit 47 each have 1 bit output, then four-memory block unit and output circuit are further necessitated.

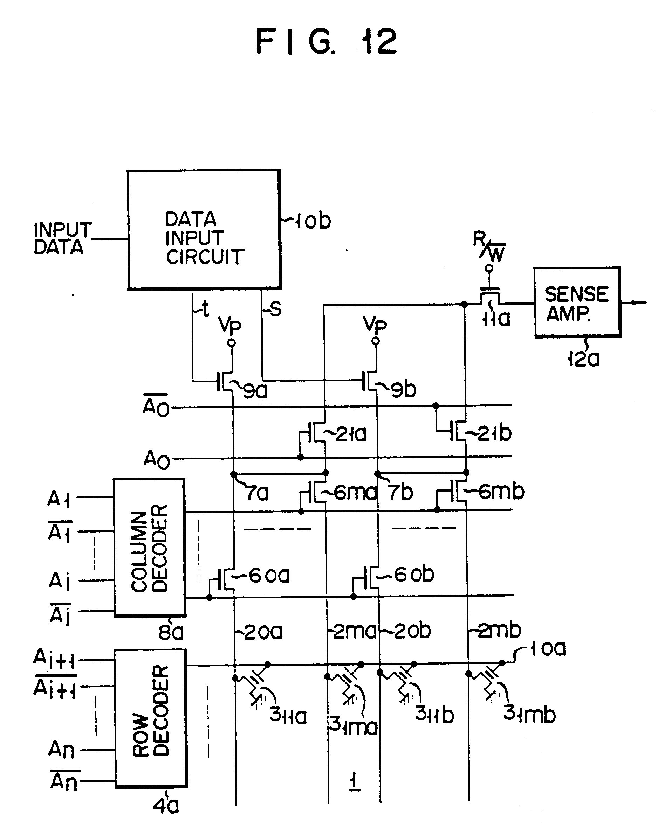

Fig. 12 shows still another embodiment of a nonvolatile semiconductor memory

This circuit is different from the circuit of Fig. 2 with respect to only data input circuit. Accordingly, like numerals are used for like portions in Fig. 2. In this embodiment, a plurality of column lines associated with one output bit are divided into a plurality of groups. Data 1 and/or 0 are written into memory cells which are connected to corresponding column lines in the groups selected by the column decoder and a row line selected by the row decoder, for the purpose of the data programming. The contents of data written into the memory cells are determined by a data input circuit 10b which detects a voltage level of the input data having more than 2 voltage levels. The present embodiment is suitable for the program test and the normal data programming as well.

An input data voltage applied to data input circuit 10b is set at 0 V, 5 V, 10 V or 15 V. Relationships between logic levels of outputs s̄ and t̄ of data input circuit 10b and input data voltage are shown in Table 1 given below.

TABLE 1

| Input data | s | t |
|---|---|---|
| 0 V | 0 | 0 |
| 5 V | 1 | 0 |
| 10 V | 0 | 1 |
| 15 V | 1 | 1 |

The logic 1 level of output s̄ and t̄ indicates the program voltage Vp (25 V), while the logic 0 level indicates 0 V.

When the input data is at 0 V, the outputs s̄ and t̄ of data input circuit 10b are at logic 0 level. Therefore, FET's 9a and 9b are OFF. As a result, the program voltage Vp is not applied to the column lines, and the contents of the memory cells remain zero. In this case, logic 0 corresponds to the neutral state of floating-gate. In other words, the logic 0 data is written into a memory cell, in each column line group, selected by row decoder and column decoder.

When the input data is at 5 V, since s = 1 and t = 0, FET 9b turns on. At this time, if the row line 10a and the column line 20b are selected by decoders 4a and 8a, logic 1 data is written into memory cell $3_{11b}$. Since FET 9a remains off, the content of memory cell $3_{11a}$ remains zero. In other words, zero is written into memory cell $3_{11a}$.

When the input data is at 10 V, since s = 0 and t = 1, FET 9a turns on. At this time, if memory cells $3_{11a}$ and $3_{11b}$ are selected by row decoder 4a and column decoder 8a, logic 1 data is written into memory cell $3_{11a}$. When the input data is at 15 V, since s = 1 and t = 1, both FET's 9a and 9b turn on. If memory cells $3_{11a}$ and $3_{11b}$ are selected, logic 1 data is simultaneously written into these memory cells.

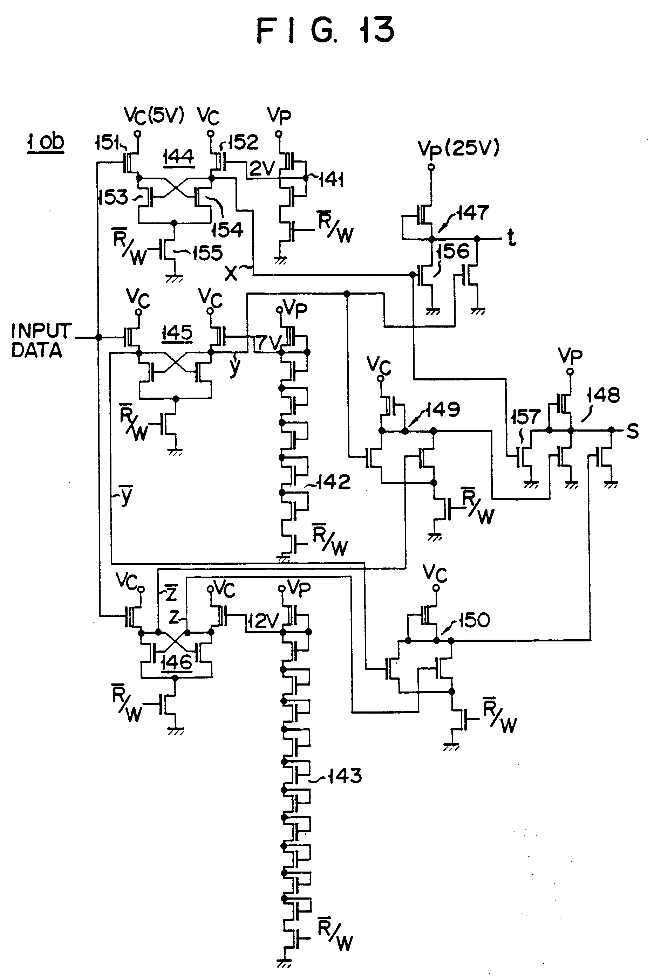

In Fig. 13, a practical arrangement of the data input circuit for executing logic functions shown in the Table 1 is illustrated.

In Table 2, logic levels of outputs s̄ and t̄ of the circuit and at points of X, Y and Z are tabulated. The logic 1 level at points X, Y and Z indicates a voltage Vc (5 V, for example), and the logic 1 level of outputs s̄ and t̄ represents the program voltage Vp.

TABLE 2

| Input data | x | y | z | s | t |
|---|---|---|---|---|---|
| 0 V | 1 | 1 | 1 | 0 | 0 |
| 5 V | 0 | 1 | 1 | 1 | 0 |
| 10 V | 0 | 0 | 1 | 0 | 1 |
| 15 V | 0 | 0 | 0 | 1 | 1 |

In the circuit shown in Fig. 13, reference numerals 141, 142 and 143 designate reference voltage generating circuits which are enabled by-the signal R̄/W to generate reference voltages of 2 V, 7 V and 12 V, respectively. The reference voltages 2 V, 7 V and 12 V are compared with the voltage of input data by

6

voltage comparators 144, 145 and 146, respectively. On the basis of the result of the voltage comparison, gate circuits 147 to 150 are controlled to determine the logic levels at outputs s and t.

For example, if the input data is at 0 V, a resistance value of an FET 151 supplied with the input data at its gate is larger than a resistance value of an FET 152 supplied with the reference voltage of 2 V at its gate. Therefore, an FET 153 is ON while an FET 154 is OFF. And when an FET 155 is enabled by the write instruction signal $\overline{R}$/W of logic 1, an output x of voltage comparator 144 goes to logic 1. As a result, FFT's 156 and 157 of gate circuit 147 and 148 turn on to cause the outputs s and t to go to logic 0 level, as shown in Table 2. Also, in case that the input data is at another voltage level, a logic operation is performed according to Table 2. As will be evident, by changing the voltage of input data according to a combination of write-data to memory cells, the program data can be simultaneously written into the memory cells.

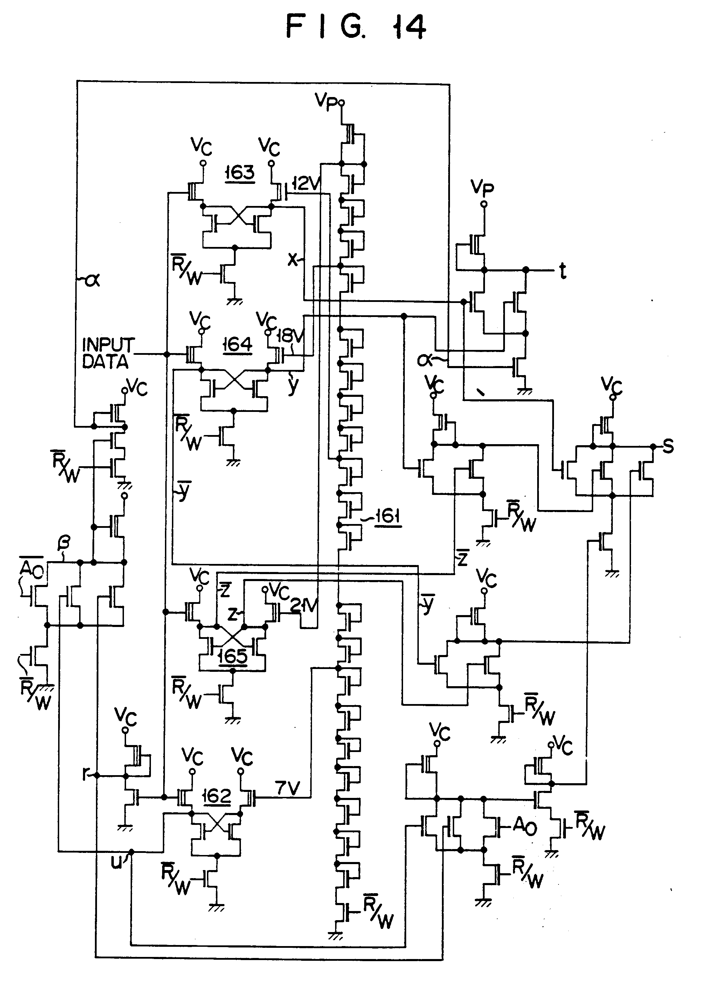

In Fig. 14, another arrangement of data input circuit 10b is shown. A reference voltage generating section 161 generates reference voltages of 7 V, 12 V, 18 V and 21 V. These reference voltages are compared with the input data voltage in the voltage comparator 162 to 165, respectively. This circuit can write 1 into one memory cell selected by address signals when the input data is at 5 V. When the input data is at 10 V, 15 V, 20 V or 25 V, a pair of memory cells having different addresses can be simultaneously programmed. Further, two-bit program data can be applied to two memory cells at the same time.

The circuit of Fig. 14 operates according to Table 3 given below.

TABLE 3

| Input data | x | y | z | u | α | β | γ | s | t |
|---|---|---|---|---|---|---|---|---|---|
| 0 V | 1 | 1 | 1 | 0 | 1 | 0 | 1 | 0 | 0 |
| 5 V | 1 | 1 | 1 | 0 | ※ | ※ | 0 | ※ | ※ |
| 10 V | 1 | 1 | 1 | 1 | 1 | 0 | 0 | 0 | 0 |
| 15 V | 0 | 1 | 1 | 1 | 1 | 0 | 0 | 1 | 0 |
| 20 V | 0 | 0 | 1 | 1 | 1 | 0 | 0 | 0 | 1 |
| 25 V | 0 | 0 | 0 | 1 | 1 | 0 | 0 | 1 | 1 |

Particulars of the symbol ※ in Table 3 are as follows:

|  | α | β | γ | s | t |
|---|---|---|---|---|---|
| when A0 = 0 | 1 | 0 | 0 | 1 | 0 |
| when A0 = 1 | 0 | 1 | 0 | 0 | 1 |

More specifically, when the input data is at 5 V and A0 = 0, in the circuit of Fig. 12, FET 9b turns on so that data 1 is written into one of the memory cells connected to the column lines 20b, ..., 2mb. On the other hand, when A0 = 1, FET 9a turns on so that data 1 is loaded into one of the memory cells connected with the column lines 20a, ..., 2ma.

When the input data is at 10 V, since s = t = 0, data 0 is written into a couple of the memory cells connected to two column lines selected by column decoder 8a and to a row line selected by row decoder 4a. When the input data is at 15 V, since s = 1 and t = 0, data 1 is written into one of the memory cells connected to column lines 2ob, ..., 2mb, and data 0 is written into one of the memory cells connected to column lines 2oa, ..., 2ma. When the input data is at 20 V, since s = 0 and t = 1, data 1 is written into one of the memory cells connected with column lines 2oa, ..., 2ma, and data 0 is written into one of the memory cells connected with column lines 2ob, ..., 2mb. And when the input data is at 25 V, since s = t = 1, data 1 is written into a pair of memory cells concurrently.

In this case, as stated above, program data can be applied to a plurality of memory cells at the same time. Therefore, a data latch time is not necessary. In the memory shown in Fig. 12, a memory area corresponding to 1 output bit is divided into two groups. Therefore, the programming time is halved compared with that of the prior art. Generally, if the memory area is divided into n groups, the programming time is reduced to 1/n of that of the prior art. And in this case, the input data has $2^n$ voltage levels.

The number of the aforesaid gate signals Y1, Y2 is not limited to two, but may be three or more. The

7

signals Y1, Y2 may be supplied through input pads. Alternatively, input signals (for example, address input signals) may be used for the signals Y1, Y2. While the cases where the present invention is applied to a ROM have been described, the present invention is also applicable to a RAM (random access memory). Namely, also in a read/write RAM memory cells having different addresses can be selected and written simultaneously by using a special signal according to the teachings described in connection with the illustrated embodiments of this invention. Further, through the embodiment of this invention were described in connection with 1 word x 4 bit memory, this invention may be applied to 1 word x 1 bit memory or 1 word x 8 bit memory.

Attention is drawn to related application No 81304660.4 from which the present application has been divided.

## Claims

1. A semiconductor memory comprising a plurality of memory arrays ($31_1$-$31_4$) each having a plurality of memory cells arranged in a matrix form with column lines and row lines and a plurality of bit outputs, decoder means ($33_1$-$33_4$, $34_1$-$34_4$) responsive to first address signals (A2-A7) to select corresponding memory cells in said memory arrays, a plurality of data write circuits ($36_1$, $37_1$-$36_4$ $37_4$) coupled to said memory arrays for writing data into corresponding memory arrays, and a write circuit selecting circuit (45) responsive to second address signals (A0, A1) to select one of said write circuits ($36_1$, $37_1$) to write data into a corresponding memory array ($31_1$), characterized in that said memory further comprises multiple-write means responsive to a control signal (MW1, MW2) to modify said second address signals (A0, A1), in a program test mode for testing the ability of the memory, so as to cause said write circuit selecting circuit (45) to select simultaneously more than one of said memory arrays ($31_1$-$31_4$) whereby the same test data to be programmed which is applied to the memory cell is written immediately into the selected arrays.

2. A memory as claimed in claim 1, wherein said decoder means comprises column and row decoders ($33_1$, $34_1$; $33_2$, $34_2$; $33_3$,$34_3$; $33_4$, $34_4$) provided for each of said memory arrays.

3. A memory as claimed in claim 1 or 2, in which each of said memory cells is a floating gate type MOS transistor having its gate connected to a row line and its drain connected to a column line.

4. A memory as claimed in claim 1, 2 or 3, wherein said multiple-write means comprises:
    a preselected number of address buffers (52, 54) connected to said write circuit selecting circuit (45), for receiving respective ones of the second address signals (A0, A1); and
    a multi-write circuit (51) connected with said address buffers (52, 54), for setting the second signals (A0, A1) in the multi-write mode simultaneously in response to the control signal (MW1, MW2).

## Revendications

1. Mémoire à semiconducteur comprenant une pluralité de matrices de mémoire ($31_1$-$31_4$) comportant chacune une pluralité de cellules de mémoire disposées sous forme matricielle avec des fils de colonne et des fils de ligne et une pluralité de sorties de bit, des moyens décodeurs ($33_1$-$33_4$,$34_1$-$34_4$) réagissant à des premiers signaux d'adresse (A2-A7) pour sélectionner des cellules de mémoire correspondantes dans lesdites matrices de mémoire, une pluralité de circuits d'écriture de données ($36_1$,$37_1$-$36_4$,$37_4$) couplés auxdites matrices de mémoire pour écrire des données dans des matrices de mémoire correspondantes, et un circuit de sélection de circuit d'écriture (45) réagissant à des deuxièmes signaux d'adresse (A0,A1) pour sélectionner un desdits circuits d'écriture ($36_1$,$37_1$) pour l'écriture de données dans une matrice de mémoire correspondante ($31_1$), caractérisée en ce que ladite mémoire comprend en outre un moyen d'écriture multiple réagissant à un signal de commande (MW1,MW2) pour modifier lesdits deuxièmes signaux d'adresse (A0,A1), dans un mode de test de programme pour tester la capacité de la mémoire, de manière à faire en sorte que ledit circuit de sélection de circuit d'écriture (45) sélectionne simultanément plus d'une desdites matrices de mémoire ($31,$-$31_4$), la même donnée de test à programmer qui est appliquée à la cellule de mémoire étant ainsi écrite immédiatement dans les matrices sélectionnées.

2. Mémoire selon la revendication 1, dans laquelle lesdits moyens décodeurs comprennent des décodeurs de colonne et de ligne ($33_1,34_1;33_2,34_2;33_3,34_3;33_4,34_4$) prévus pour chacune desdites matrices de mémoire.

3. Mémoire selon l'une quelconque des revendications 1 et 2, dans laquelle chacune desdites cellules de mémoire est un transistor à métal-oxyde-semiconducteur MOS du type à grille flottante dont la grille est connectée à un fil de ligne et dont le drain est connecté à un fil de colonne.

4. Mémoire selon l'une quelconque des revendications 1 à 3, dans laquelle ledit moyen d'écriture multiple comprend:

un nombre présélectionné de tampons d'adresse (52,54) connectés audit circuit de sélection de circuit d'écriture (45), pour recevoir des signaux respectifs des deuxièmes signaux d'adresse (A0,A1); et

un circuit d'écriture multiple (51) connecté auxdits tampons d'adresse (52,54), pour mettre les deuxièmes signaux (A0,A1) dans le mode d'écriture multiple simultanément en réponse au signal de commande (MW1,MW2).

## Patentansprüche

1. Halbleiterspeicher, umfassend eine Vielzahl von Speicherarrays ($31_1$-$31_4$) mit jeweils einer Anzahl von in einer Matrixform mit Spalten- und Zeilenleitungen und einer Anzahl von Bitausgängen angeordneten Speicherzellen, eine Decodierereinheit ($33_1$-$33_4$, $34_1$-$34_4$), die auf erste Adreßsignale (A2-A7) anspricht, um entsprechende Speicherzellen in den Speicherarrays zu wählen, eine Anzahl von mit den Speicherarrays gekoppelten Dateneinschreibkreisen ($36_1$, $37_1$-$36_4$, $37_4$) zum Einschreiben von Daten in die betreffenden Speicherarrays und eine auf zweite Adreßsignale (A0, A1) ansprechende Einschreibkreis-Wählschaltung (45) zum Wählen (Anwählen) einer der Einschreibkreise ($36_1$, $37_1$) für das Einschreiben von Daten in ein betreffendes Speicherarray ($31_1$), gekennzeichnet durch eine auf ein Steuersignal (MW1, MW2) ansprechende Mehrfacheinschreibeinrichtung zum Modifizieren der zweiten Adreßsignale (A0, A1) in einem Programmtestmodus zum Testen der (Betriebs-)Fähigkeit des Speichers, um die Einschreibkreis-Wählschaltung (45) gleichzeitig mehr als eines der Speicherarrays ($31_1$-$31_4$) (an)wählen zu lassen, wobei die gleichen zu programmierenden Testdaten, die der Speicherzelle aufgeprägt werden, unmittelbar in die gewählten Arrays eingeschrieben werden.

2. Speicher nach Anspruch 1, dadurch gekennzeichnet, daß die Decodierereinheit für jedes der Speicherarrays vorgesehene Spalten- und Zeilendecodierer ($33_1$, $34_1$; $33_2$, $34_2$; $33_3$, $34_3$; $33_4$, $34_4$) umfaßt.

3. Speicher nach Anspruch 1 oder 2, dadurch gekennzeichnet, daß jede der Speicherzellen ein Floating Gate-MOS-Transistor ist, dessen Gateelektrode mit einer Zeilenleitung und dessen Drainelektrode mit einer Spaltenleitung verbunden sind.

4. Speicher nach Anspruch 1, 2 oder 3, dadurch gekennzeichnet, daß die Mehrfacheinschreibeinrichtung umfaßt:

eine vorgewählte Zahl von mit der Einschreibkreis-Wählschaltung (45) verbundenen Adreßpuffern (52, 54) zum Abnehmen jeweiliger der zweiten Adreßsignale (A0, A1) und

einen mit den Adreßpuffern (52, 54) verbundenen Mehrfacheinschreibkreis (51) zum gleichzeitigen Setzen der zweiten Signale (A0, A1) im Mehrfacheinschreibmodus in Abhängigkeit vom Steuersignal (MW1, MW2).

# F I G. 1

F I G. 2

F I G. 3

EP 0 214 705 B1

12

# F I G. 4

# F I G. 5

# F I G. 6

# F I G. 7

14

# F I G. 8

# F I G. 9

# F I G. 10

F I G. 11

# F I G. 12

# F I G. 13

# F I G. 14